# EUROPEAN PATENT APPLICATION

(11) **EP 4 210 077 A1**
(43) Date of publication of application: **12.07.2023**
(21) Application number: 21868332.4
(22) Date of filing: 05.08.2021
(51) Int. Cl.: H01G 4/224, H01G 4/232

(54) **ELECTRONIC COMPONENT AND ELECTRONIC DEVICE**

(30) Priority: 18.09.2020 CN 202022071522 U
(71) Applicant: Huawei Technologies Co., Ltd., Shenzhen, Guangdong 518129 (CN)
(72) Inventor: SHI, Hongbin, Shenzhen, Guangdong 518129 (CN)
(74) Representative: Huawei European IPR
(86) International application number: PCT/CN2021/111022
(87) International publication number: WO 2022/057504

(57) **Abstract**

Embodiments of this application disclose an electronic component and an electronic device. The electronic component is disposed on a printed circuit board PCB. The electronic component includes an electronic component body. The electronic component body is soldered to the PCB by using a connecting component. The connecting component is provided with at least one cushioning structure. In this way, the connecting component is provided with the at least one cushioning structure, so that stress may be released at a position of the cushioning structure when the electronic component is subjected to mechanical stress. Stress on the electronic component body is reduced, and the electronic component body is prevented from cracking under the stress, thereby improving reliability of the electronic component.

## Description

This application claims priority to Chinese Patent Application No. 202022071522.4, filed with the China National Intellectual Property Administration on September 18, 2020 and entitled "ELECTRONIC COMPONENT AND ELECTRONIC DEVICE", which is incorporated herein by reference in its entirety.

### TECHNICAL FIELD

Embodiments of this application relate to the field of capacitor technologies, and in particular, to an electronic component and an electronic device.

### BACKGROUND

With the rapid development of the world electronics industry, as the basic elements of the electronics industry, multi-layer ceramic capacitors (Multi-layer Ceramic Capacitors, MLCC) are widely used in electronic products.

Electronic components are usually disposed on a printed circuit board (Printed Circuit Board, PCB), and are soldered to the PCB.

However, when the PCB is subjected to stress, bending occurs. The electronic component includes a ceramic medium. When the electronic component is subjected to stress, cracking occurs. As a result, an internal circuit of an electronic product is short-circuited or disconnected. Sensitivity of the electronic product is affected, or the electronic product fails.

### SUMMARY

Embodiments of this application provide an electronic component and an electronic device and resolve a problem of poor reliability of the electronic component.

To achieve the foregoing objective, the following technical solutions are used in the embodiments of this application. According to a first aspect of an embodiment of this application, an electronic component is provided. The electronic component is disposed on a PCB. The electronic component includes an electronic component body. The electronic component body is soldered to the PCB by using a connecting component. The connecting component is provided with at least one cushioning structure. In this way, the connecting component is provided with the at least one cushioning structure, so that stress may be released at a position of the cushioning structure when the electronic component is subjected to mechanical stress. Stress on the electronic component body is reduced, and the electronic component body is prevented from cracking under the stress, thereby improving reliability of the electronic component.

According to the first aspect, in a possible design, the cushioning structure is in a rectangular, circular, or irregular shape. The cushioning structure and the connecting component form a "rectangular-ambulatory-plane" structure. Therefore, the stress may be released at the cushioning structure.

According to the first aspect, in a possible design, a shape of the cushioning structure includes any one of the following: a straight line shape, a curve shape, and a zigzag line shape. Therefore, the shape of the cushioning structure is more flexible.

According to the first aspect, in a possible design, there is one cushioning structure. The connecting component includes a first side and a second side that are opposite to each other. The cushioning structure passes through the first side and the second side of the connecting component. Therefore, the cushioning structure may divide a force-bearing surface of the connecting component into two independent parts, so that the stress cannot be continuously transferred to the electronic component body. Reliability of the electronic component is improved.

According to the first aspect, in a possible design, there are two cushioning structures. The two cushioning structures are disposed in a cross shape. The two cushioning structures respectively pass through two opposite sides of the connecting component. Therefore, the cushioning structures may further divide the force-bearing surface of the connecting component into four independent parts, so that the stress cannot be continuously transferred to the electronic component body. Reliability of the electronic component is improved.

According to the first aspect, in a possible design, the connecting component includes a pad. The pad is provided with at least one cushioning structure. Therefore, the connecting component has a simple structure and is easy to assemble.

According to the first aspect, in a possible design, the connecting component includes a pad and a connecting material. The connecting material is located between the pad and the electronic component body. The connecting material is provided with at least one cushioning structure. In this way, connection stability is improved by providing the connecting material. Moreover, it is easier to operate because an original mechanism of the pad does not need to be changed.

According to the first aspect, in a possible design, the connecting material includes at least one of solder and electrically conductive adhesive.

According to the first aspect, in a possible design, the electronic component further includes termination electrodes covering two ends of the electronic component body. The termination electrodes are soldered to the circuit board by using the connecting material. Therefore, the electronic component body may be connected to the PCB more stably.

According to the first aspect, in a possible design, the electronic component body is connected to the termination electrodes by using electrically conductive resin or the electrically conductive adhesive. In this way, the elastomeric conductive material may better absorb the mechanical stress applied to the electronic component body. The electronic component body is prevented from cracking under the stress, and reliability of the electronic component is improved.

According to the first aspect, in a possible design, the cushioning structure includes at least one of the following: an opening disposed on the connecting component, and a cushioning member disposed between the connecting component and the electronic component body. In this way, stress may be released by using the opening or the cushioning member. Stress on the electronic component body is reduced, and the electronic component body is prevented from cracking under the stress. Reliability of the electronic component is improved.

According to the first aspect, in a possible design, the cushioning member is a solder mask layer. In this way, the electronic component body is disconnected from the PCB at a position of the solder mask layer by providing the solder mask layer. The force-bearing surface is divided, and stress cannot be continuously transferred to the electronic component body. Reliability of the electronic component is improved.

According to a second aspect of this application, an electronic device is provided. The electronic device includes a PCB and the foregoing electronic component. The electronic component is disposed on the PCB. Therefore, the foregoing electronic component has a same technical effect as the electronic component provided in the foregoing embodiment, and details are not described herein again.

### BRIEF DESCRIPTION OF DRAWINGS

FIG. 1a is a schematic diagram of a structure of a multi-layer ceramic capacitor;
FIG. 1b is a top view of a connecting component in FIG. 1a;
FIG. 2 is a sectional view of a multi-layer ceramic capacitor according to an embodiment of this application;
FIG. 2a is a top view of a connecting component according to an embodiment of this application;
FIG. 2b is a top view of a connecting component according to an embodiment of this application;
FIG. 2c is a top view of a connecting component according to an embodiment of this application;
FIG. 2d is a top view of a connecting component according to an embodiment of this application;
FIG. 3 is a schematic diagram of a structure of another multi-layer ceramic capacitor according to an embodiment of this application;
FIG. 3a is a top view of a connecting component according to an embodiment of this application;
FIG. 3b is a top view of a connecting component according to an embodiment of this application;
FIG. 3c is a top view of a connecting component according to an embodiment of this application;
FIG. 3d is a top view of a connecting component according to an embodiment of this application;
FIG. 4 is a schematic diagram of a structure of another multi-layer ceramic capacitor according to an embodiment of this application;
FIG. 4a is a top view of a connecting component according to an embodiment of this application;
FIG. 4b is a top view of a connecting component according to an embodiment of this application;
FIG. 4c is a top view of a connecting component according to an embodiment of this application;
FIG. 4d is a top view of a connecting component according to an embodiment of this application;
FIG. 5 is a schematic diagram of a structure of a multi-layer ceramic capacitor in a control group according to an embodiment of this application;
FIG. 5a is a schematic diagram of a structure of a multi-layer ceramic capacitor in Example 1;
FIG. 5b is a schematic diagram of a structure of a multi-layer ceramic capacitor in Example 2;
FIG. 5c is a schematic diagram of a structure of a multi-layer ceramic capacitor in Example 3;
FIG. 5d is a schematic diagram of a structure of a multi-layer ceramic capacitor in Example 4;
FIG. 6 is a comparison diagram of stress of capacitor bodies of multi-layer ceramic capacitors at dropping in a control group, Example 1, Example 2, Example 3, and Example 4;
FIG. 7 is a comparison diagram of strain of capacitor bodies of multi-layer ceramic capacitors at dropping in a control group, Example 1, Example 2, Example 3, and Example 4;
FIG. 8 is a comparison diagram of stress at solder joints of multi-layer ceramic capacitors at dropping in a control group, Example 1, Example 2, Example 3, and Example 4; and
FIG. 9 is a comparison diagram of stress and strain, and stress at solder joints of capacitor bodies of multi-layer ceramic capacitors at dropping in a control group, Example 1, Example 2, Example 3, and Example 4.

### DESCRIPTION OF EMBODIMENTS

To make objectives, technical solutions, and advantages of this application clearer, the following further describes this application in detail with reference to the accompanying drawings.

Terms such as "first" and "second" mentioned below are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of" means two or more than two.

In addition, in this application, position terms such as "top" and "bottom" are defined relative to positions of components in the accompanying drawings. It should be understood that these position terms are relative concepts used for relative description and clarification, and may correspondingly change based on changes in the positions of the components in the accompanying drawings.

An embodiment of this application provides an electronic device. The electronic device includes, for example, a mobile phone, a tablet computer, an in-vehicle computer, an intelligent wearable product, the Internet of Things (internet of things, IOT), and the like. A specific form of the electronic device is not specially limited in the embodiment of this application.

The electronic device includes a PCB, and an electronic component disposed on the PCB. The electronic component includes, for example, an electronic component whose body is prone to crack and fail, such as a multi-layer ceramic capacitor (Multi-layer Ceramic Capacitors, MLCC), an inductor, and a wafer level package (Wafer Level Package, WLP). The following uses an example in which the electronic component is a multi-layer ceramic capacitor MLCC for description.

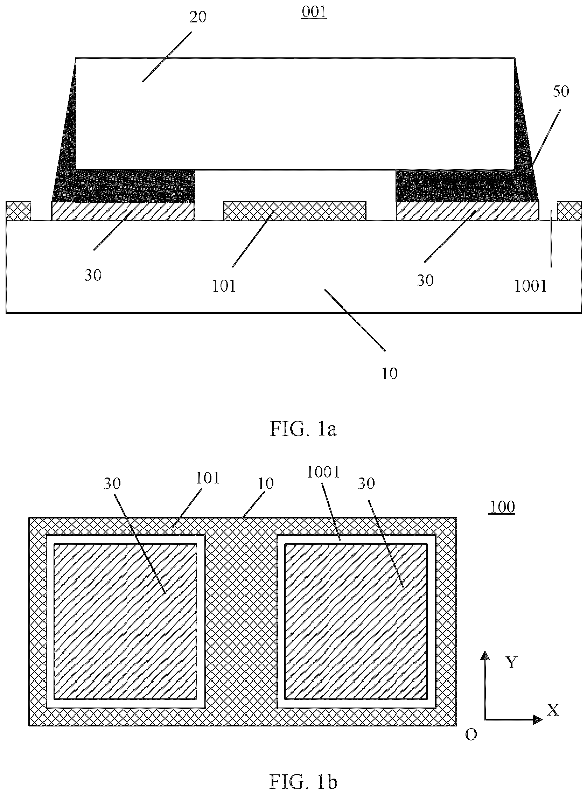

FIG. 1a is a schematic diagram of a structure of a multi-layer ceramic capacitor. As shown in FIG. 1a, the multi-layer ceramic capacitor is disposed on a printed circuit board PCB 10. The multi-layer ceramic capacitor 001 includes a capacitor body 20. The capacitor body 20 is, for example, formed by multiple layers of ceramic having electrodes. The capacitor body 20 is connected to the PCB 10 by using, for example, a connecting component. In some embodiments, the connecting component may be a pad.

FIG. 1b is a top view of a connecting component in FIG. 1a. As shown in FIG. 1a and FIG. 1b, the capacitor body 20 is soldered to pads 30 by using, for example, connecting materials 50, and the pads 30 are soldered to the PCB 10.

In some embodiments of this application, the multi-layer ceramic capacitor 001 further includes termination electrodes. The termination electrodes are soldered to the circuit board by using the connecting materials 50. A material of the connecting material 50 may be a conductive material such as solder and electrically conductive adhesive. The solder includes, for example, a tin (Sn) alloy, a silver (Ag) alloy, and a copper (Cu) alloy.

For example, the termination electrode is in a shape of "]". When the capacitor is soldered to the circuit board by using the connecting component, the connecting material 50 is partially attached to an outer side of a part that is of a termination electrode and that is close to the circuit board, and is partially located between the capacitor body 20 and a pad 30. Two ends where the connecting material 50 is attached to the termination electrode are connected to roughly form a triangle on the capacitor body 20.

A shape of the connecting material may be the triangle, or may be a trapezoid, a rectangle, or a part of a circle. Generally, a larger area covered by the connection parts indicates a better effect of preventing a short circuit.

In some embodiments, as shown in FIG. 1b, a solder mask layer 101 is disposed on a surface of the PCB 10. Openings are disposed on the solder mask layer 101. The pads 30 are disposed at the openings of the solder mask layer 101. A gap 1001 exists between the pad 30 and the solder mask layer 101. The solder mask layer 101 is not provided on surfaces of the pads 30. This design is non-solder mask defined (Non-Solder Mask Defined, NSMD) pads.

In some other embodiments, a solder mask layer 101 is disposed on a surface of the PCB 10. Openings are disposed on the solder mask layer 101. The pads 30 are disposed at the openings of the solder mask layer 101. The solder mask layer 101 is provided around the pads 30. This design is solder mask defined (Solder Mask Defined) pads.

Certainly, in some other embodiments, a solder mask layer 101 is disposed on surfaces of some pads 30, and surfaces of some pads 30 are not provided with the solder mask layer 101. This design is NSMD/SMD hybrid pads. All these fall within the protection scope of this application.

However, when the PCB 10 is subjected to an external force, bending occurs. The PCB 10 transfers stress to the capacitor body 20 through the pads 30. The capacitor body 20 cracks under the stress, and the multi-layer ceramic capacitor 001 fails.

Therefore, an embodiment of this application provides an improved multi-layer ceramic capacitor 001.

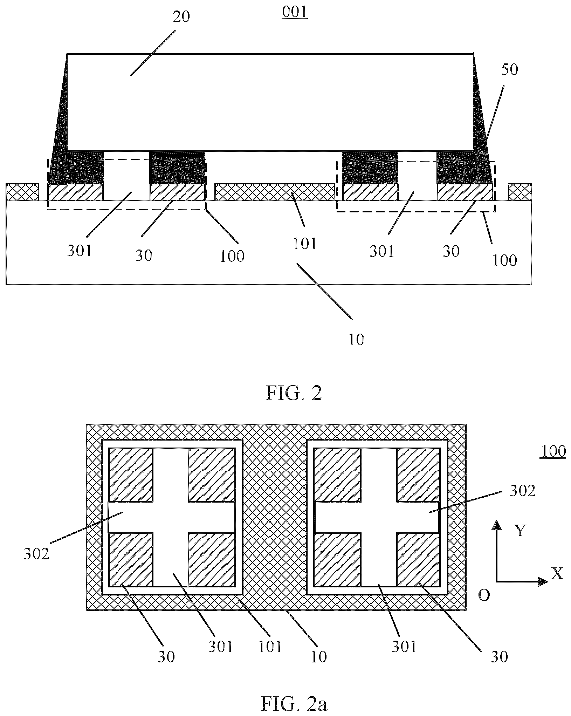

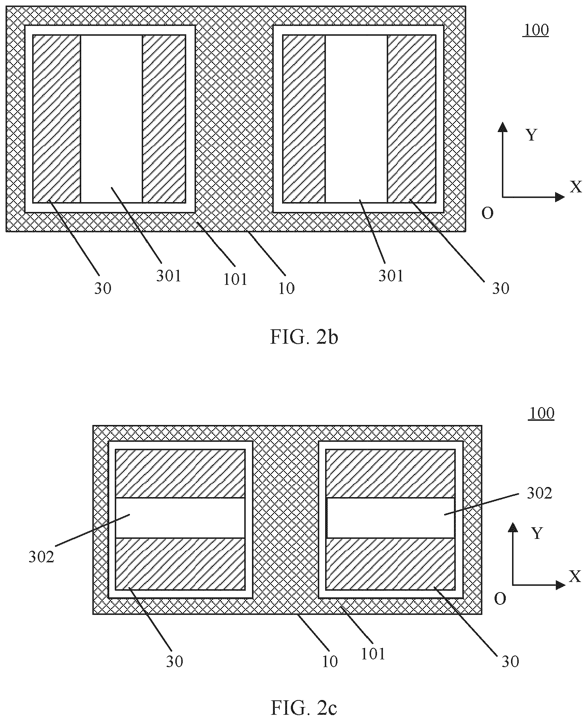

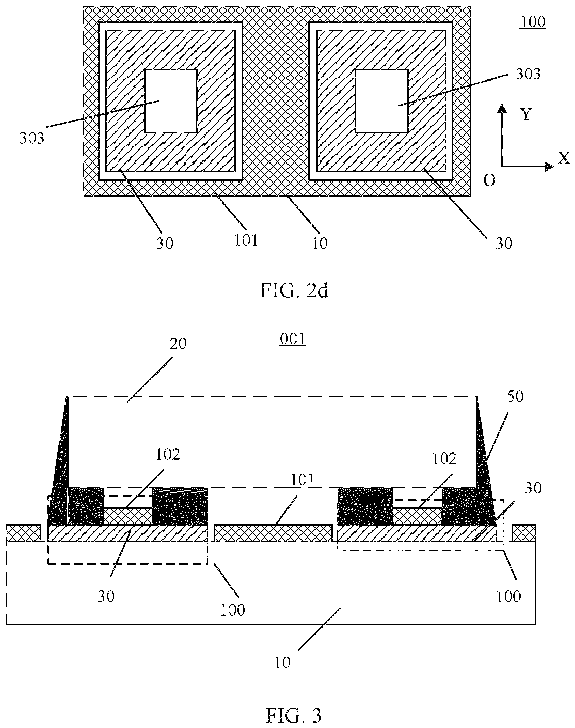

As shown in FIG. 2, the multi-layer ceramic capacitor 001 includes a capacitor body 20. The capacitor body 20 is soldered to a printed circuit board PCB 10 by using connecting components 100. The connecting component 100 is provided with at least one cushioning structure.

For example, a surface of the printed circuit board PCB 10 is provided with, for example, a solder mask layer 101. A material of the solder mask layer may be resin and have functions of moisture-proof, insulation, soldering-proof, and high temperature resistance. For example, openings are disposed on the solder mask layer 101, and the connecting component 100 is disposed at the openings.

The cushioning structure is not limited in this embodiment of this application. In some embodiments of this application, as shown in FIG. 2, the cushioning structure includes a first opening 301 disposed on the connecting component 100.

In some other embodiments of this application, the cushioning structure includes a cushioning member 102 disposed between the connecting component 100 and the capacitor body 20. The cushioning members 102 may be an elastomeric component or a solder mask layer.

According to the multi-layer ceramic capacitor 001 provided in this embodiment of this application, the connecting component 100 is provided with at least one cushioning structure, so that stress may be released at a position of the cushioning structure when the multi-layer ceramic capacitor 001 is subjected to mechanical stress. Stress on the capacitor body 20 is reduced, and the capacitor body 20 is prevented from cracking under the stress. Reliability of the multi-layer ceramic capacitor 001 is improved.

The position of the cushioning structure is not limited in this embodiment of this application. The cushioning structure may be disposed at a position where the multi-layer ceramic capacitor 001 is prone to crack. In some embodiments of this application, a middle position of the multi-layer ceramic capacitor 001 is prone to crack. Therefore, the cushioning structure may be disposed in the middle position of the capacitor body 20.

A specific structure of the connecting component 100 is not limited in this embodiment of this application. In some embodiments of this application, as shown in FIG. 2, the connecting component 100 includes a pad 30. The pad 30 is of a three-layer structure, including a capacitor body pad, a connecting material, and a PCB pad that are disposed in a stacked manner.

One surface of the capacitor body 20 is soldered to the pad 30 by using a connecting material 50, and the pad 30 is soldered to the PCB 10. A shape of the connecting material 50 between the capacitor body 20 and the pad 30 matches that of the pad 30.

In some embodiments, as shown in FIG. 2, the first opening 301 is disposed on the pad 30 as the cushioning structure.

A shape of the cushioning structure is not limited in this embodiment of this application. The shape of the cushioning structure includes any one of the following: a straight line shape, a curve shape, and a zigzag line shape, for example, a" 1"-shape, "U"-shape, "V"-shape, "W"-shape, and "S"-shape.

A quantity of cushioning structures is not limited in this embodiment of this application. In some embodiments of this application, as shown in FIG. 2a, the connecting component 100 includes a pad 30. The pad 30 is provided with two cushioning structures: a first opening 301 and a second opening 302. The first opening 301 and the second opening 302 are disposed in a cross shape.

The first opening 301 is disposed horizontally, for example, in parallel to an X-axis direction, and extends from a first side of the pad 30 to a second side of the pad 30. The second opening 302 is disposed vertically, for example, in parallel to a Y-axis direction, and extends from a third side of the pad 30 to a fourth side of the pad 30.

In addition, the first opening 301 and the second opening 302 divide the pad 30 into four blocks.

In some other embodiments of this application, as shown in FIG. 2b and FIG. 2c, there is one cushioning structure. The connecting component 100 includes, for example, a first side and a second side that are opposite to each other. The cushioning structure passes through the first side and the second side.

As shown in FIG. 2b, the first opening 301 parallel to the Y-axis direction is disposed on the pad 30. The pad 30 is divided into two blocks by the first opening 301 along the Y-axis direction. The width of the first opening 301 is, for example, one third of the length of a third side and a fourth side.

As shown in FIG. 2c, the second opening 302 parallel to the X-axis direction is disposed on the pad 30. The pad 30 is divided into two blocks by the second opening 302 along the X-axis direction. The width of the second opening 302 is one third of the length of the first side and the second side.

In some other embodiments of this application, the cushioning structure is in a rectangular, circular, or irregular shape, and is disposed at a central position of the capacitor body 20. As shown in FIG. 2d, third openings 303 are disposed in the middle of the capacitor body 20, and a cross section of the capacitor body 20 is in a "rectangular-ambulatory-plane" shape.

According to the multi-layer ceramic capacitor 001 provided in this embodiment of this application, the openings are provided on the pads 30, so that in a conventional design of completely soldered pads 30, effectiveness of transferring deformation of the PCB 10 to the fragile capacitor body 20 is reduced. Therefore, stress and strain of the capacitor body 20 are reduced, and a ceramic cracking risk of the capacitor body 20 is thus reduced. Board-level application reliability of the multi-layer ceramic capacitor 001 is improved.

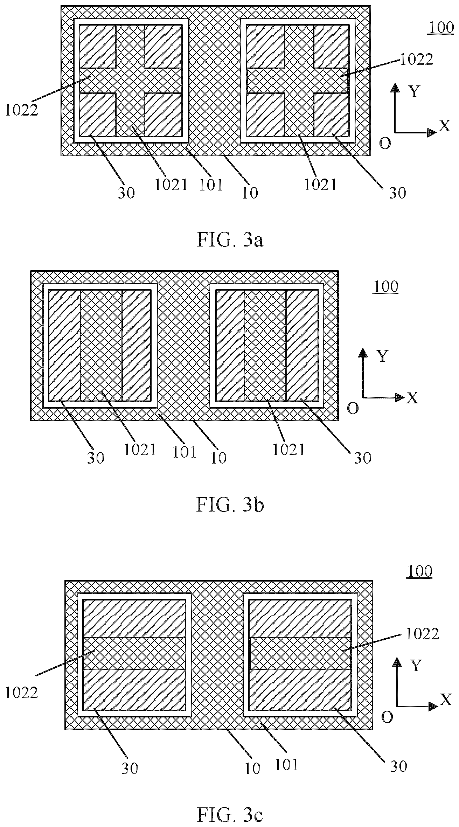

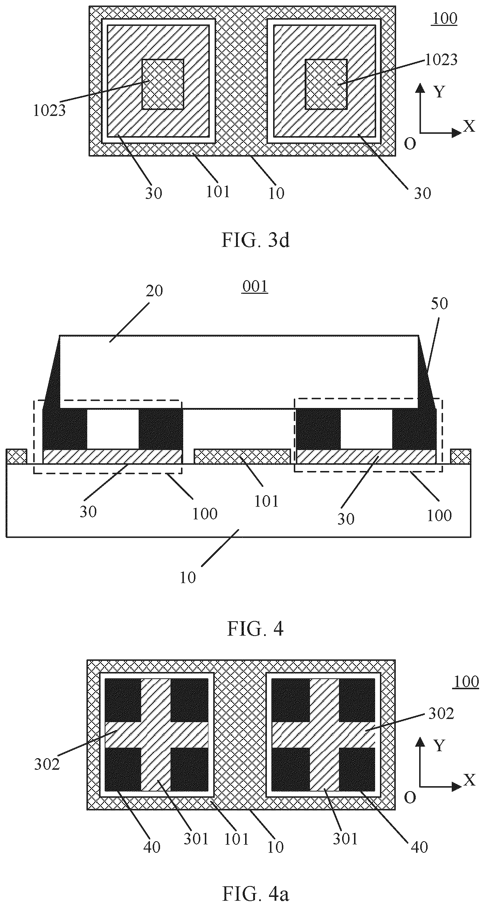

In some other embodiments, as shown in FIG. 3, a cushioning member 102 is disposed between the pad 30 and the capacitor body 20. An opening is disposed on a connecting material 50 between the pad 30 and the capacitor body 20. The cushioning member 102 is located in the opening, and a height of the connecting material 50 between the pad 30 and the capacitor body 20 is higher than that of the cushioning member 102.

In some embodiments of this application, as shown in FIG. 3a, the connecting component 100 includes the pad 30. The pad 30 is provided with two cushioning structures: a first cushioning member 1021 and a second cushioning member 1022. The first cushioning member 1021 and the second cushioning member 1022 are disposed in a cross shape.

The first cushioning member 1021 is disposed horizontally, for example, in parallel to an X-axis direction, and extends from the first side of the pad 30 to the second side of the pad 30. The second cushioning member 1022 is disposed vertically, for example, in parallel to a Y-axis direction, and extends from the third side of the pad 30 to the fourth side of the pad 30.

In addition, the first cushioning member 1021 and the second cushioning member 1022 divide the pad 30 into four blocks.

In some other embodiments of this application, a quantity of cushioning structures is not limited in this embodiment of this application. In some embodiments of this application, as shown in FIG. 3b and FIG. 3c, there is one cushioning structure. The connecting component 100 includes, for example, a first side and a second side that are opposite to each other. The cushioning structure passes through the first side and the second side.

As shown in FIG. 3b, the first cushioning member 1021 parallel to the Y-axis direction is disposed on the pad 30. The pad 30 is divided into two blocks by the first cushioning member 1021 along the Y-axis direction. The width of the first cushioning member 1021 is, for example, one third of the length of a third side and a fourth side.

As shown in FIG. 3c, the second cushioning member 1022 parallel to the X-axis direction is disposed on the pad 30. The pad 30 is divided into two blocks by the second cushioning member 1022 along the X-axis direction. The width of the second cushioning member 1022 is one third of the length of the first side and the second side.

In some embodiments of this application, the cushioning structure is in a rectangular, circular, or irregular shape, and is disposed at the central position of the capacitor body 20. As shown in FIG. 3d, third cushioning members 1023 are disposed in the middle position of the capacitor body 20, and a top view of the capacitor body 20 is in a "rectangular-ambulatory-plane" shape.

According to the multi-layer ceramic capacitor 001 provided in this embodiment of this application, in a conventional design of completely soldered pads 30, effectiveness of transferring deformation of the PCB 10 to the fragile capacitor body 20 is reduced by using a design of locally disposing the cushioning layers 102. Therefore, stress and strain of the capacitor body 20 are reduced, and a ceramic cracking risk of the capacitor body 20 is thus reduced. Board-level application reliability of the multi-layer ceramic capacitor 001 is improved.

In some other embodiments of this application, the connecting component 100 includes a pad 30 and a connecting material 50. The connecting material 50 is partially located between the pad 30 and the capacitor body 20. The connecting material 50 is provided with the at least one cushioning structure.

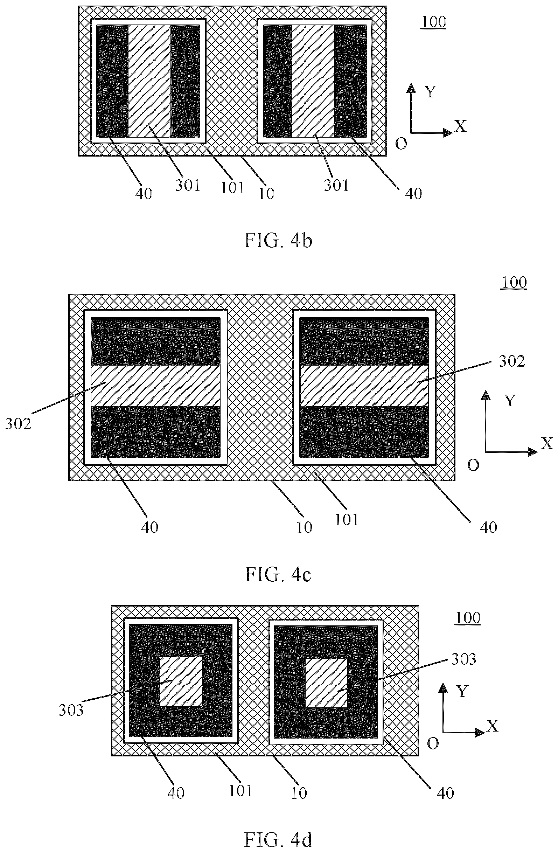

In some embodiments, as shown in FIG. 4, an opening is disposed on the connecting material 50 between the capacitor body 20 and the pad 30 to serve as the cushioning structure.

In some embodiments of this application, as shown in FIG. 4a, the connecting material 50 is provided with two cushioning structures: a first opening 301 and a second opening 302. The first opening 301 and the second opening 302 are disposed in a cross shape.

The first opening 301 is horizontally disposed, for example, in parallel to an X-axis direction, and extends from a first side of the connecting material 50 to a second side of the connecting material 50. The second opening 302 is vertically disposed, for example, in parallel to a Y-axis direction, and extends from a third side of the connecting material 50 to a fourth side of the connecting material 50.

In addition, the first opening 301 and the second opening 302 divide the connecting material 50 into four blocks.

In some other embodiments of this application, a quantity of cushioning structures is not limited in this embodiment of this application. In some embodiments of this application, as shown in FIG. 4b and FIG. 4c, there is one cushioning structure. The connecting component 100 includes, for example, a first side and a second side that are opposite to each other. The cushioning structure passes through the first side and the second side.

As shown in FIG. 4b, the first opening 301 parallel to the Y-axis direction is disposed on the connecting material 50. The connecting material 50 is divided into two blocks by the first opening 301 along the Y-axis direction. The width of the first opening 301 is, for example, one third of the length of the third side and the fourth side.

As shown in FIG. 4c, the second opening 302 parallel to an X-axis direction is disposed on the connecting material 50. The connecting material 50 is divided into two blocks by the second opening 302 along the X-axis direction. The width of the second opening 302 is one third of the length of the first side and the second side.

In some embodiments of this application, the cushioning structure is in a rectangular, circular, or irregular shape, and is disposed at the central position of the capacitor body 20. As shown in FIG. 4d, third openings 303 are disposed in the middle of the capacitor body 20, and a cross section of the capacitor body 20 is in a "rectangular-ambulatory-plane" shape.

According to the multi-layer ceramic capacitor 001 provided in this embodiment of this application, in a conventional design of completely soldered pads 30, effectiveness of transferring deformation of the PCB 10 to the fragile capacitor body 20 is reduced by using a design of locally disposing the openings in the connecting materials 50. Therefore, stress and strain of the capacitor body 20 are reduced, and a ceramic cracking risk of the capacitor body 20 is thus reduced. Board-level application reliability of the multi-layer ceramic capacitor 001 is improved.

In some other embodiments, a cushioning member 102 is disposed between the connecting material 50 and the capacitor body 20 to serve as a cushioning structure (not shown in the figure).

The following describes drop simulation tests on the multi-layer ceramic capacitors 001 having different cushioning structure shapes.

A 0805 multi-layer ceramic capacitor 001 is used as an example, where 0805 represents a size specification of the capacitor and is represented by inches: 08 represents that the length is 0.08 inches, corresponding to 2.0 mm, and 05 represents that the width is 0.05 inches, corresponding to 1.27 mm.

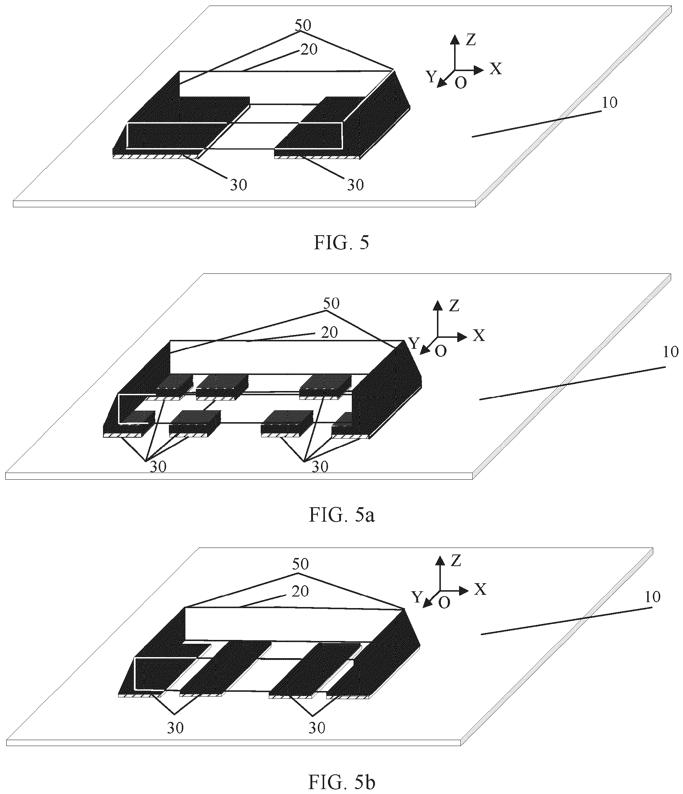

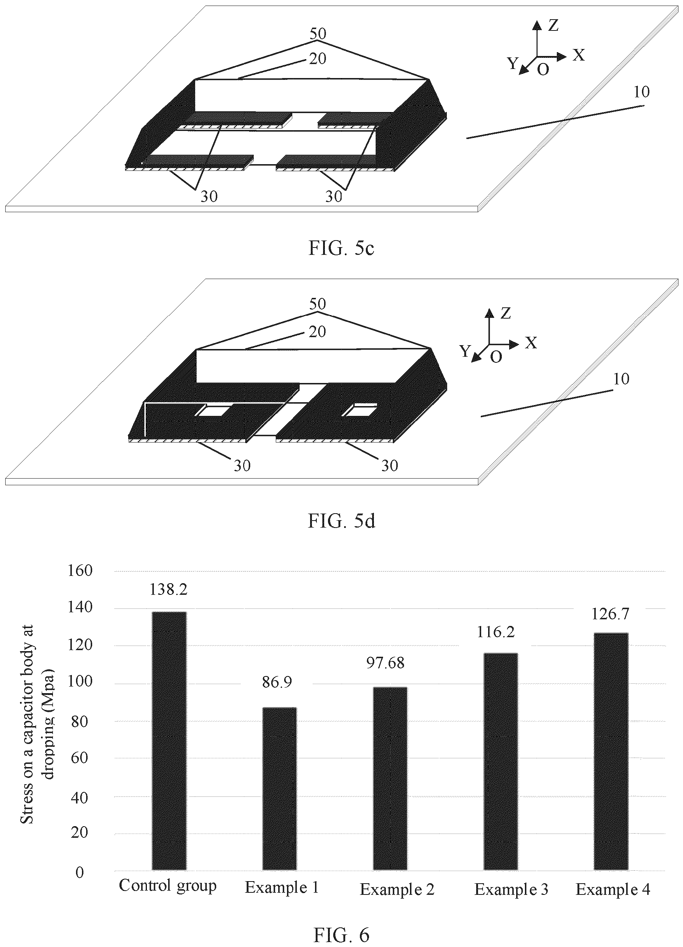

As shown in FIG. 5, FIG. 5a, FIG. 5b, FIG. 5c, and FIG. 5d, a multi-layer ceramic capacitor 001 includes: a capacitor body 20, a connecting component 100, and a printed circuit board 10. The capacitor body 20 is connected to the printed circuit board by using the connecting component.

The connecting component includes a pad 30 and a connecting material 50. A cross-sectional shape and size of the pad 30 are the same as those of the capacitor body 20. For example, an opening is disposed on the pad 30 to serve as a cushioning structure.

FIG. 5 is a control group. As shown in FIG. 5, the multi-layer ceramic capacitor 001 in the control group is not provided with a cushioning structure.

Example 1: As shown in FIG. 5a, the pad 30 is provided with two openings: a first opening and a second opening. The first opening and the second opening are disposed in a cross shape.

The first opening is, for example, in parallel to an X-axis direction, and extends from a first side of the pad 30 to a second side of the pad 30. The second opening is, for example, in parallel to a Y-axis direction, and extends from a third side of the pad 30 to a fourth side of the pad 30.

In addition, the first opening and the second opening divide the pad 30 into four blocks. The width of the first opening is a quarter of the length of the first side and the second side, and the width of the second opening is a quarter of the length of the third side and the fourth side.

Example 2: As shown in FIG. 5b, the first opening parallel to the Y-axis direction is disposed on the pad 30. The pad 30 is divided into two blocks by the first opening along the Y-axis direction. The width of the first opening is, for example, one third of the length of the third side and the fourth side.

Example 3: As shown in FIG. 5c, the second opening parallel to the X-axis direction is disposed on the pad 30. The pad 30 is divided into two blocks by the second opening along the X-axis direction. The width of the second opening is one third of the length of the first side and the second side.

Example 4: As shown in FIG. 5d, a third opening is disposed at a central position of the pad 30. The third opening is, for example, in a rectangular shape, and a cross section of the pad 30 is in a "rectangular-ambulatory-plane" shape. The lengths of horizontal and longitudinal sides of the third opening 303 are respectively a quarter of the lengths of horizontal and longitudinal sides of the corresponding pad 30.

The multi-layer ceramic capacitor is, for example, disposed on the PCB 10. The thickness of the PCB 10 is 0.65 mm.

During a drop simulation test, an impact acceleration is 1500 G/1 ms.

Figure 6 shows simulation results of the drop test. As shown in FIG. 6, stress of the capacitor body 20 of the multi-layer ceramic capacitor 001 at dropping in the control group is 138.2 MPa. Stress of the capacitor body 20 at dropping in Example 1 is 86.9 MPa. Stress of the capacitor body 20 at dropping in Example 2 is 97.68 MPa. Stress of the capacitor body 20 at dropping in Example 3 is 116.2 MPa. Stress of the capacitor body 20 at dropping in Example 4 is 126.7 MPa. Therefore, the capacitor body 20 in Example 1 has the smallest stress at dropping.

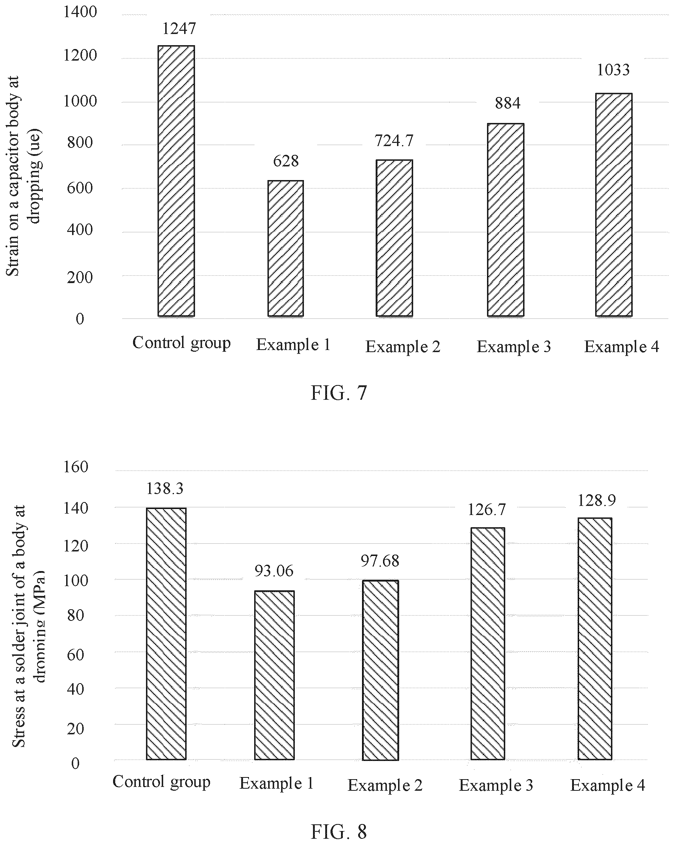

As shown in FIG. 7, strain of the multi-layer ceramic capacitor 001 at dropping in the control group is 1247 ue. Strain of the multi-layer ceramic capacitor 001 at dropping in Example 1 is 628 ue. Strain of the multi-layer ceramic capacitor 001 at dropping in Example 2 is 724.7 ue. Strain of the multi-layer ceramic capacitor 001 at dropping in Example 3 is 884 ue. Strain of the multi-layer ceramic capacitor 001 at dropping in Example 4 is 1033 ue. The multi-layer ceramic capacitor 001 in Example 1 has the smallest strain at dropping.

As shown in FIG. 8, stress at a solder joint of the multi-layer ceramic capacitor 001 at dropping in the control group is 138.3 MPa. Stress at a solder joint of the multi-layer ceramic capacitor 001 at dropping in Example 1 is 93.06 MPa. Stress at a solder joint of the multi-layer ceramic capacitor 001 at dropping in Example 2 is 97.68 MPa. Stress at a solder joint of the multi-layer ceramic capacitor 001 at dropping in Example 3 is 126.7 MPa. Stress at a solder joint of the multi-layer ceramic capacitor 001 at dropping in Example 4 is 128.9 MPa. Therefore, the multi-layer ceramic capacitor 001 in Example 1 has the smallest stress at the solder joint at dropping.

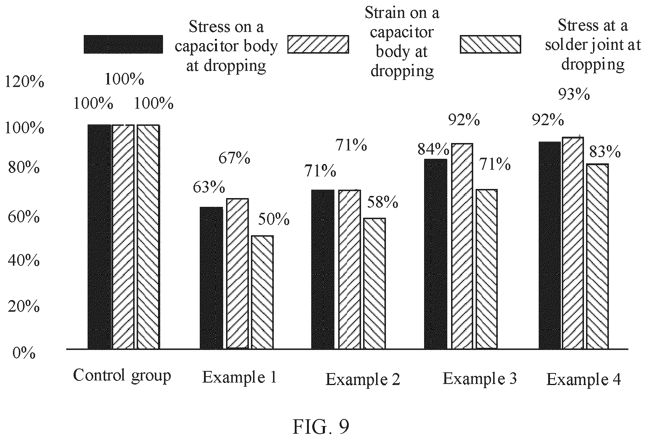

FIG. 9 shows improvement situations of the stress of the capacitor body 20 at dropping, the strain of the capacitor body 20 at dropping, and the stress at the solder joint at dropping that are of the multi-layer ceramic capacitor 001 when compared with those the conventional design.

As shown in FIG. 9, in Example 1, the stress of the capacitor body 20 at dropping decreases by 37% when compared with that of the control group. The strain of the capacitor body 20 at dropping decreases by 33% when compared with that of the control group. The stress at the solder joint of the multi-layer ceramic capacitor 001 at dropping decreases by 50% when compared with that of the control group.

In Example 2, the stress of the capacitor body 20 at dropping decreases by 29% when compared with that of the control group. The strain of the capacitor body 20 at dropping decreases by 29% when compared with that of the control group. The stress at the solder joint of the multi-layer ceramic capacitor 001 at dropping decreases by 42% when compared with that of the control group.

In Example 3, the stress of the capacitor body 20 at dropping decreases by 16% when compared with that of the control group. The strain of the capacitor body 20 at dropping decreases by 8% when compared with that of the control group. The stress at the solder joint of the multi-layer ceramic capacitor 001 at dropping decreases by 29% when compared with that of the control group.

In Example 4, the stress of the capacitor body 20 at dropping decreases by 8% when compared with that of the control group. The strain of the capacitor body 20 at dropping decreases by 7% when compared with that of the control group. The stress at the solder joint of the multi-layer ceramic capacitor 001 at dropping decreases by 17% when compared with that of the control group.

In conclusion, the openings are provided on the pads 30, so that the stress and strain of the capacitor body 20 at dropping, and the stress at the solder joint of the capacitor body 20 at dropping decrease. The cushioning structures in the cross shape may minimize the stress and strain of the capacitor body 20 at dropping and the stress at the solder joint at dropping.

In some embodiments of this application, the capacitor body 20 may be connected to the termination electrodes by using an elastomeric conductive material such as the electrically conductive resin or the electrically conductive adhesive.

The elastomeric conductive material can better absorb mechanical stress acting on the capacitor body 20. The capacitor body 20 is prevented from cracking under stress, and reliability of the multi-layer ceramic capacitor 001 is improved.

The foregoing descriptions are only specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An electronic component, wherein the electronic component is disposed on a printed circuit board PCB, the electronic component comprises an electronic component body, the electronic component body is soldered to the PCB by using a connecting component, and the connecting component is provided with at least one cushioning structure.

2. The electronic component according to claim 1, wherein the cushioning structure comprises at least one of the following: an opening disposed on the connecting component, and a cushioning member disposed between the connecting component and the electronic component body.

3. The electronic component according to claim 1 or 2, wherein a shape of the cushioning structure comprises any one of the following: a straight line shape, a curve shape, a zigzag line shape, or an irregular shape.

4. The electronic component according to claim 3, wherein there is one cushioning structure, the connecting component comprises: a first side and a second side that are opposite to each other, and the cushioning structure passes through the first side and the second side of the connecting component.

5. The electronic component according to claim 3, wherein the cushioning structure is disposed at a middle position of a connecting component, and forms a rectangular-ambulatory-plane structure with the connecting component.

6. The electronic component according to claim 3, wherein there are two cushioning structures, the two cushioning structures are disposed in a cross shape, and the two cushioning structures respectively pass through two opposite sides of the connecting component.

7. The electronic component according to any one of claims 1 to 2 and claims 4 to 6, wherein the connecting component comprises a pad, and the pad is provided with the at least one cushioning structure.

8. The electronic component according to any one of claims 1 to 2 and claims 4 to 6, wherein the connecting component comprises a pad and a connecting material, the connecting material is located between the pad and the electronic component body, and the connecting material is provided with the at least one cushioning structure.

9. The electronic component according to claim 8, wherein the connecting material comprises at least one of solder and electrically conductive adhesive.

10. The electronic component according to any one of claims 1 to 2, 4 to 6, and 9, wherein the electronic component further comprises: a termination electrode covering two ends of the electronic component body, and the termination electrode is soldered to the circuit board by using the connecting material.

11. The electronic component according to claim 10, wherein the electronic component body is connected to the termination electrode by using electrically conductive resin or electrically conductive adhesive.

12. The electronic component according to claim 2, wherein the cushioning member is a solder mask layer.

13. An electronic device, wherein the electronic device comprises a PCB and the electronic component according to any one of claims 1 to 12, and the electronic component is disposed on the PCB.
